# EUROPEAN PATENT SPECIFICATION

(11) **EP 3 961 832 B1**
(45) Date of publication and mention of the grant of the patent: **11.12.2024**
(21) Application number: 19926470.6
(22) Date of filing: 22.04.2019
(51) Int. Cl.: H02B 13/065, H02B 3/00, H02B 13/035, H02B 13/075, G01R 31/327, G01R 31/12, G01R 31/14

(54) **FAULT-POINT-LOCATING DEVICE**
VORRICHTUNG ZUR FEHLERPUNKTORTUNG
DISPOSITIF DE LOCALISATION DE POINT DE DÉFAUT

(43) Date of publication of application: 02.03.2022
(73) Proprietor: MITSUBISHI ELECTRIC CORPORATION, Chiyoda-ku Tokyo 100-8310 (JP)
(72) Inventor: TAMURA, Yoshiyuki, Tokyo 100-8310 (JP)
(74) Representative: Witte, Weller & Partner Patentanwälte mbB
(86) International application number: PCT/JP2019/017021
(87) International publication number: WO 2020/217275

(56) References cited:
- JP-A- 2001 314 009
- JP-A- 2002 131 366
- JP-A- H0 823 628
- JP-A- H0 879 923
- JP-A- H0 879 923
- JP-A- H02 183 928
- JP-A- H02 275 372
- JP-A- H06 313 776
- JP-A- H07 245 832
- JP-A- H1 141 782
- JP-A- S57 125 189

## Description

### Field

The present invention relates to a fault-point-locating device that locates a fault point in a three-phase separating gas-insulated switchgear.

### Background

A conventional fault-point-locating device monitors the pressure in each tank equivalent to a gas section, and detects an increase in the pressure caused by a ground fault or a short circuit, so as to locate a fault point where the ground fault or the short circuit has occurred. In a breaker tank in which a breaker is accommodated, the pressure in the tank can also be increased due to an arc generated during current interruption other than the ground fault or the short circuit. The fault-point-locating device is thus required to be capable of distinguishing a short circuit in the breaker tank from current interruption by a breaker.

Patent Literature 1 discloses a fault-point-locating device provided with current transformers between a breaker tank and each of the tanks adjacent to the breaker tank, so as to monitor a ground fault in the breaker tank on the basis of the polarity of a current flowing through each of the current transformers. According to Patent Literature 1, in order to monitor a ground fault in the breaker tank forming a three-phase simultaneous gas-insulated switchgear, the current transformers are provided respectively between the breaker tank and a busbar tank, between the breaker tank and a cable head tank, and between the breaker tank and an earth.

Patent Literature 2 relates to a failure point locating device.

Patent Literature 3, according to its abstract, states that, to enable location of a fault point by a method wherein a plurality of terminals are provided in an electromagnetic direction of a ground fault current path and current between terminals is checked to detect a ground fault current easily with handy construction, a transmission wire is arranged near center axes of gas insulated switch (GIS) tanks made up of a conductor of a low impedance and filled with SF6 gas. Then, terminals are connected to a nut connected to flanges and ground fault current sensors are provided between the respective terminals. In such a condition, when a ground fault occurs at a point P, a ground fault current flows through the tanks in a direction of earth centered on the point P, thereby enabling detection thereof with the sensors. When phases of the sensors are compared, any ground fault point P can be located when existing within a detection section of a ground fault current sensor with normal and opposite phases adjacent to each other.

Patent Literature 4, according to its abstract, states that, to get the information of an accident early by accurately judging an accident block, using the magnitude of a zero-phase current for detection of an accident, a gas-insulated switchgear, where a container for accommodating each element is divided into a plurality of gas blocks, are provided with a current detector, which detects the currents of three-phase buses built in insulating spacers for dividing each gas block, a current change detector, which seeks the temporal change from the output of the zero phase current detector, and an accident block judging part, which judges the gas block of accident occurrence by comparing the magnitude of the zero-phase current with the specified judgment level.

### Citation List

### Patent Literature

Patent Literature 1: Japanese Patent Application Laid-open No. H8-79923
Patent Literature 2: JP S57 125189 A
Patent Literature 3: JP H02 275372 A
Patent Literature 4: JP H07 245832 A

### Summary

### Technical Problem

In a case where a three-phase separating gas-insulated switchgear monitors a ground fault in a breaker tank for each phase, when the technique disclosed in Patent Literature 1 described above is applied to the three-phase separating gas-insulated switchgear, the number of current transformers required for this gas-insulated switchgear is three times larger than that required for a three-phase simultaneous gas-insulated switchgear. Thus, many current transformers are needed for locating a fault point in the breaker tanks. According to the technique disclosed in Patent Literature 1 described above, there is a problem that the gas-insulated switchgear needs to be provided with many constituent elements to locate a fault point.

The present invention has been achieved to solve the above problems, and an object of the present invention is to provide a fault-point-locating device that makes it possible to reduce the number of constituent elements to be provided in a gas-insulated switchgear to locate a fault point in a tank in which a breaker is accommodated.

### Solution to Problem

According to the present disclosure, fault-point-locating devices as defined in the independent claims are provided. Further embodiments of the invention are defined in the dependent claims. Although the invention is only defined by the claims, the below embodiments, examples, and aspects are present for aiding in understanding the background and advantages of the invention.

### Advantageous Effects of Invention

The fault-point-locating device according to the present invention has an effect where it is possible to reduce the number of constituent elements to be provided in a gas-insulated switchgear to locate a fault point in a tank in which a breaker is accommodated.

### Brief Description of Drawings

FIG. 1 is a block diagram illustrating a configuration of a fault-point-locating device according to a first embodiment of the present invention.
FIG. 2 is a diagram illustrating a schematic configuration of a gas-insulated switchgear that is a target for locating a fault point by the fault-point-locating device illustrated in FIG. 1.
FIG. 3 is a diagram for explaining a process to be performed by a location processing unit included in the fault-point-locating device illustrated in FIG. 1.
FIG. 4 is a first diagram illustrating an example of a hardware configuration of the fault-point-locating device according to the first embodiment.
FIG. 5 is a second diagram illustrating an example of the hardware configuration of the fault-point-locating device according to the first embodiment.
FIG. 6 is a diagram illustrating a schematic configuration of a gas-insulated switchgear that is a target for locating a fault point by a fault-point-locating device according to a second embodiment of the present invention. Description of Embodiments

A fault-point-locating device according to embodiments of the present invention will be described in detail below with reference to the drawings. The invention is defined by the appended claims.

### First embodiment.

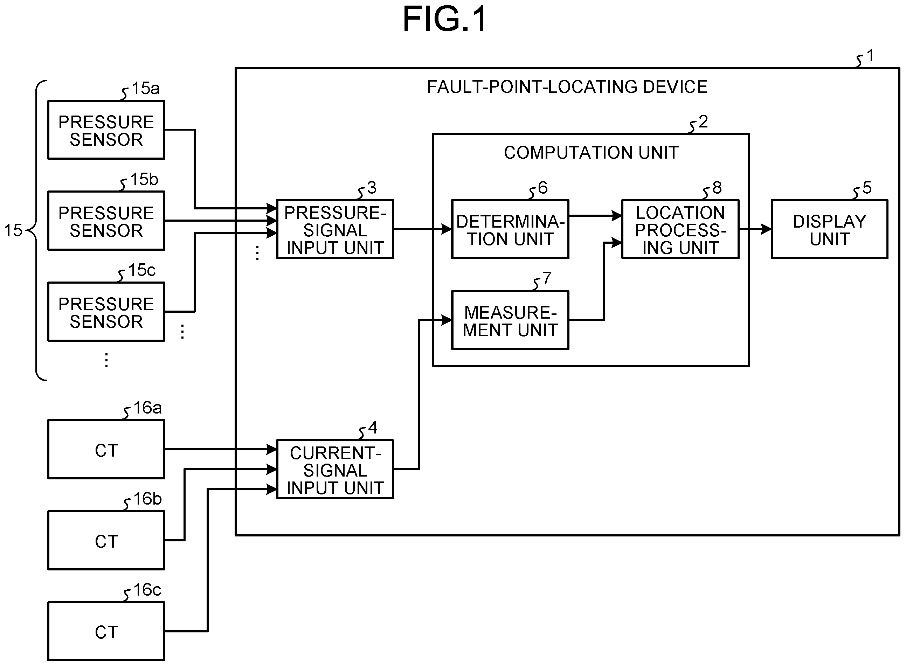

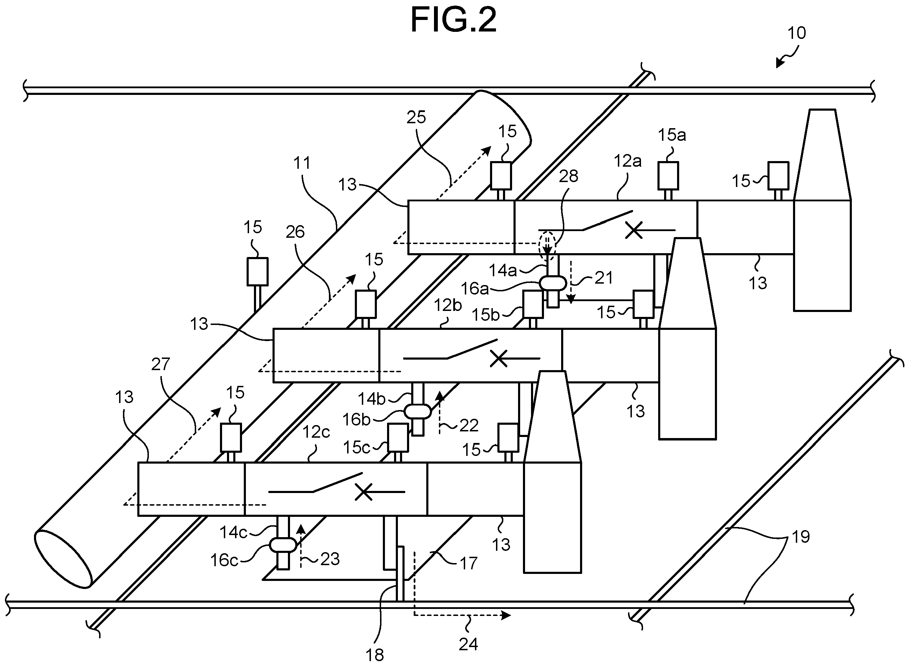

FIG. 1 is a block diagram illustrating a configuration of a fault-point-locating device according to a first embodiment of the present invention. FIG. 2 is a diagram illustrating a schematic configuration of a gas-insulated switchgear that is a target for locating a fault point by the fault-point-locating device illustrated in FIG. 1. A gas-insulated switchgear 10 illustrated in FIG. 2 is installed in power facilities such as a power plant or a substation.

In the gas-insulated switchgear 10, a voltage is applied to a busbar for three phases including a U-phase, a V-phase, and a W-phase. Wires for the three phases branch off from the busbar toward a target to/from which power is transmitted/received. Breakers are connected to branch wires that are the wires that branch off from the busbar. The busbar, the branch wires, and the breakers are accommodated respectively in tanks filled with insulating gas. The gas-insulated switchgear 10 is a so-called "three-phase separating gas-insulated switchgear" in which the branch wires for three phases are individually accommodated in separate tanks. In the three-phase separating gas-insulated switchgear, a ground fault may occur, while a phase-to-phase short circuit does not occur.

The gas-insulated switchgear 10 includes a breaker tank 12a that is a first tank, a breaker tank 12b that is a second tank, and a breaker tank 12c that is a third tank. A breaker for a U-phase that is a first phase is accommodated in the breaker tank 12a. A breaker for a V-phase that is a second phase is accommodated in the breaker tank 12b. A breaker for a W-phase that is a third phase is accommodated in the breaker tank 12c. The busbar is accommodated in a busbar tank 11. Tanks other than the busbar tank 11 and the breaker tanks 12a, 12b, and 12c are connection tanks 13. A branch wire or a device connected to the branch wire is accommodated in each of the connection tanks 13.

The busbar tank 11, the breaker tanks 12a, 12b, and 12c, and the connection tanks 13 illustrated in FIG. 1 form a single unit. A plurality of units are provided in the gas-insulated switchgear 10.

The breaker tank 12a is installed on a stand 14a. The breaker tank 12b is installed on a stand 14b. The breaker tank 12c is installed on a stand 14c. The busbar tank 11 and the connection tanks 13 are installed on their respective stands similarly to the breaker tanks 12a, 12b, and 12c. FIG. 2 omits illustrations of the stand on which the busbar tank 11 is installed, and the stands on which the connection tanks 13 are installed.

The stands 14a, 14b, and 14c are installed on a metal base 17. The stand 14a supports the breaker tank 12a on the metal base 17. The stand 14b supports the breaker tank 12b on the metal base 17. The stand 14c supports the breaker tank 12c on the metal base 17. The metal base 17 is provided in each unit.

A grounding electrode 18 is connected to the metal base 17. The breaker tanks 12a, 12b, and 12c are connected to the grounding electrode 18 through the stands 14a, 14b, and 14c, respectively, and through the metal base 17. The grounding electrode 18 connects the metal base 17 to a grounding mesh 19. The grounding mesh 19 is provided underground in the power facilities. The grounding mesh 19 is made of copper wires laid into a net. The spacing between the copper wires is approximately 1 meter to 10 meters. Each of the copper wires has a cross-sectional area of approximately 100 mm².

The busbar tank 11, the breaker tanks 12a, 12b, and 12c, and the connection tanks 13 are provided respectively with pressure sensors 15. Each of the pressure sensors 15 detects the pressure in the tank. The pressure sensor 15 provided on the breaker tank 12a is referred to as "pressure sensor 15a". The pressure sensor 15 provided on the breaker tank 12b is referred to as "pressure sensor 15b". The pressure sensor 15 provided on the breaker tank 12c is referred to as "pressure sensor 15c".

Current transformers (CTs) 16a, 16b, and 16c detect a current. The CT 16a is attached to one of the columns that form the stand 14a. The CT 16b is attached to one of the columns that form the stand 14b. The CT 16c is attached to one of the columns that form the stand 14c. The CT 16a, 16b, or 16c is a so-called "through-type current transformer".

A fault-point-locating device 1 illustrated in FIG. 1 locates a fault point in the gas-insulated switchgear 10. The fault-point-locating device 1 is installed along with the gas-insulated switchgear 10 in the power facilities. Each of the pressure sensors 15 provided in the gas-insulated switchgear 10 is connected to the fault-point-locating device 1 through a signal line. Each of the pressure sensors 15 outputs a pressure signal indicating the result of pressure detection to the fault-point-locating device 1. Each of the CTs 16a, 16b, and 16c provided in the gas-insulated switchgear 10 is connected to the fault-point-locating device 1 through a signal line. Each of the CTs 16a, 16b, and 16c outputs a current signal indicating the result of current detection to the fault-point-locating device 1.

The fault-point-locating device 1 includes a computation unit 2 to perform various types of computational processing, a pressure-signal input unit 3 to which a pressure signal is input from each of the pressure sensors 15, a current-signal input unit 4 to which a current signal is input from each of the CTs 16a, 16b, and 16c, and a display unit 5 to display information. The computation unit 2 includes a determination unit 6 to determine whether a pressure increase has occurred in each of the tanks, a measurement unit 7 to measure a current waveform, and a location processing unit 8 to perform a process of locating a fault point. The determination unit 6 processes a pressure signal to determine whether a pressure increase has occurred. The measurement unit 7 processes a current signal to measure a current waveform. The display unit 5 displays the result of location of the fault point by the location processing unit 8.

Location of a fault point by the fault-point-locating device 1 is described here. The determination unit 6 monitors whether a pressure increase has occurred in the busbar tank 11 and the connection tanks 13 on the basis of pressure signals from the pressure sensors 15 provided on the busbar tank 11 and the connection tanks 13. When the determination unit 6 determines that a pressure increase has occurred in any one of the busbar tank 11 and the connection tanks 13, the location processing unit 8 locates the tank in which a pressure increase is determined to have occurred as a fault point. As described above, when a ground fault has occurred in any of the busbar tank 11 and the connection tanks 13, the location processing unit 8 determines a fault point in the busbar tank 11 and the connection tanks 13 on the basis of the result of determination performed by the determination unit 6 regarding whether a pressure increase has occurred.

On the basis of pressure signals from the pressure sensors 15a, 15b, and 15c, the determination unit 6 monitors whether a pressure increase has occurred in the breaker tanks 12a, 12b, and 12c. On the basis of current signals from the CTs 16a, 16b, and 16c, the measurement unit 7 monitors whether the CTs 16a, 16b, and 16c have detected a current. That is, the measurement unit 7 monitors whether a current flows from the breaker tank 12a via the stand 14a to the grounding electrode 18, monitors whether a current flows from the breaker tank 12b via the stand 14b to the grounding electrode 18, and monitors whether a current flows from the breaker tank 12c via the stand 14c to the grounding electrode 18. When the CTs 16a, 16b, and 16c have detected a current, the measurement unit 7 measures a waveform of the current detected by each CT.

When a pressure increase is determined to have occurred in one of the breaker tanks 12a, 12b, and 12c, and when a current flowing between the one breaker tank and the grounding electrode 18 is out of phase with a current flowing between either of the other two breaker tanks and the grounding electrode 18, and a current flowing between the other of the other two breaker tanks and the grounding electrode 18, then the location processing unit 8 locates the one breaker tank as a fault point. In the manner as described above, on the basis of the determination result of whether a pressure increase has occurred, and the measurement result of the waveform of the currents, the location processing unit 8 performs a process of locating a fault point in the breaker tank 12a, the breaker tank 12b, and the breaker tank 12c.

As illustrated in FIG. 2, it is assumed that a ground fault has occurred at a position 28 in the breaker tank 12a. Due to the occurrence of a ground fault in the breaker tank 12a, the pressure in the breaker tank 12a increases.

Due to the ground fault, a ground-fault current 25, that is a portion of the current having flowed between the branch wire and the breaker tank 12a, flows from the breaker tank 12a through the connection tank 13 and the busbar tank 11 to a transformer that is a power supply in the power facilities. In addition, a ground-fault current 21, that is a portion of the current having flowed between the branch wire and the breaker tank 12a, flows through the stand 14a to the metal base 17. The CT 16a detects the ground-fault current 21. A ground-fault current 24, that is a portion of the ground-fault current 21 having flowed to the metal base 17, flows from the metal base 17 through the grounding electrode 18 and the grounding mesh 19 to the transformer.

A ground-fault current 22, that is a portion of the ground-fault current 21 having flowed to the metal base 17, flows from the metal base 17 through the stand 14b to the breaker tank 12b. The CT 16b detects the ground-fault current 22. A ground-fault current 26, that is a portion of the ground-fault current 22 having flowed to the breaker tank 12b, flows from the breaker tank 12b through the connection tank 13 and the busbar tank 11 to the transformer.

A ground-fault current 23, that is a portion of the ground-fault current 21 having flowed to the metal base 17, flows from the metal base 17 through the stand 14c to the breaker tank 12c. The CT 16c detects the ground-fault current 23. A ground-fault current 27, that is a portion of the ground-fault current 23 having flowed to the breaker tank 12c, flows from the breaker tank 12c through the connection tank 13 and the busbar tank 11 to the transformer.

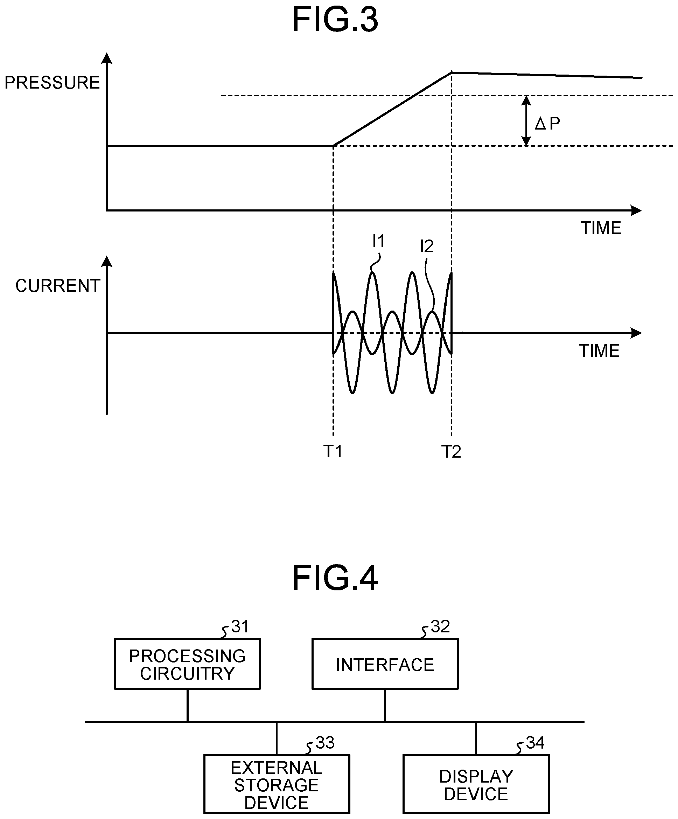

FIG. 3 is a diagram for explaining a process to be performed by the location processing unit included in the fault-point-locating device illustrated in FIG. 1. A graph illustrated on the upper side of FIG. 3 shows a relation between time and a pressure detected by the pressure sensor 15a. A graph illustrated on the lower side of FIG. 3 shows a relation between time and a current detected by the CTs 16a and 16b.

A time T1 represents the time at which a ground fault has occurred at the position 28. When a ground fault has occurred at the position 28, the gas-insulated switchgear 10 causes respective breakers in the breaker tanks 12a, 12b, and 12c to perform an opening operation. A time T2 represents the time at which current interruption is completed by the opening operation of the breakers. The ground fault continues during the period from the time T1 to the time T2.

Since a ground fault has occurred at the position 28, the pressure detected by the pressure sensor 15a increases during the period from the time T1 to the time T2. At or after the time T2, the pressure gradually decreases due to heat dissipation from the breaker tank 12a. When the pressure detected by the pressure sensor 15a starts increasing, and then the amount of pressure increase becomes greater than a threshold ΔP set in advance, then the determination unit 6 determines that a pressure increase has occurred. The threshold ΔP is set for each individual tank on the basis of the result of calculation of a minimum pressure increase at the occurrence of a ground fault. It is allowable that the threshold ΔP is set to a different value for each individual tank, or is set to a common value among all the tanks provided in the gas-insulated switchgear 10.

As a ground fault has occurred at the position 28, the ground-fault currents 21, 22, 23, 24, 25, 26, and 27 are generated. When the CT 16a detects the ground-fault current 21, the measurement unit 7 measures the current waveform of the ground-fault current 21 on the basis of a current signal from the CT 16a. When the CT 16b detects the ground-fault current 22, the measurement unit 7 measures the current waveform of the ground-fault current 22 on the basis of a current signal from the CT 16b. When the CT 16c detects the ground-fault current 23, the measurement unit 7 measures the current waveform of the ground-fault current 23 on the basis of a current signal from the CT 16c. The graph on the lower side of FIG. 3 illustrates a current waveform I1 of the ground-fault current 21 and a current waveform I2 of the ground-fault current 22.

Since the ground-fault current 21 and the ground-fault current 22 flow in directions opposite to each other, the current waveform I1 and the current waveform I2 have opposite phases to each other. That is, the ground-fault current 21 is 180 degrees out of phase with the ground-fault current 22. Since the ground-fault current 23 and the ground-fault current 22 flow in the same direction, the current waveform of the ground-fault current 23 is in phase with the current waveform 12. That is, there is not phase shifting between the ground-fault current 23 and the ground-fault current 22. Therefore, only the current waveform I1, that is one of the three current waveforms obtained by measurement by the measurement unit 7, is out of phase with the other two current waveforms. Illustrations of the current waveform of the ground-fault current 23 are omitted since the current waveform of the ground-fault current 23 is identical to the current waveform I2 except that the current waveform of the ground-fault current 23 has an amplitude different from that of the current waveform 12.

The location processing unit 8 locates the breaker tank 12a as a fault point on the basis of the determination in the determination unit 6 that a pressure increase has occurred in the breaker tank 12a, and on the basis of the fact that only the current waveform I1 of the current waveforms measured by the measurement unit 7 is out of phase with the other current waveforms. When a ground fault has occurred in the breaker tank 12b or the breaker tank 12c, the location processing unit 8 also locates the fault point in the same manner as performed on the breaker tank 12a.

In the breaker tanks 12a, 12b, and 12c, when the breaker interrupts the current due to reasons other than the ground fault, the ground-fault currents 21, 22, and 23 are not detected, while the determination unit 6 determines that a pressure increase has occurred. Accordingly, on the basis of whether the ground-fault currents 21, 22, and 23 are detected, the location processing unit 8 can distinguish a short circuit having occurred in the breaker tanks 12a, 12b, and 12c from current interruption performed by the breaker due to reasons other than the ground fault.

The path through which the ground-fault currents 25, 26, and 27 flow from the breaker tanks 12a, 12b, and 12c through the connection tanks 13 and the busbar tank 11 to the power supply has an impedance lower than the impedance on the path through which the ground-fault current 24 flows through the grounding electrode 18 and the grounding mesh 19 to the power supply. A specific example is given in which the grounding mesh 19 has an impedance per unit distance, where the value of impedance is of the order of magnitude of 1 ohm, and in contrast to that, the surface of the tank has an impedance per unit distance, where the value of impedance is of the order of magnitude of 10 milliohms. The value of impedance on the path passing through the surface of the tank is smaller by an order of magnitude than the value of impedance on the path passing through the grounding mesh 19. Accordingly, the paths of the ground-fault currents 25, 26, and 27 have a lower impedance than that on the path of the ground-fault current 24.

When the ground-fault current 21 flows to the metal base 17, then due to the difference between the impedance values as described above, the ground-fault current 24 flows to the grounding electrode 18, and additionally the ground-fault currents 22 and 23 flow through the stands 14b and 14c to the breaker tanks 12b and 12c, respectively, and further the ground-fault currents 26 and 27 flow from the breaker tanks 12b and 12c, respectively, to the busbar tank 11. In this manner, the ground-fault current 22 flowing through the stand 14b to the breaker tank 12b is generated, and the ground-fault current 23 flowing through the stand 14c to the breaker tank 12c is generated, making it possible for the CTs 16b and 16c to detect the ground-fault currents 22 and 23 whose current amount is sufficient for the measurement unit 7 to measure a current waveform.

In the fault-point-locating device 1, three CTs 16a, 16b, and 16c are installed per unit, so that the fault-point-locating device 1 can monitor a ground fault in the breaker tanks 12a, 12b, and 12c. The fault-point-locating device 1 can locate a fault point by using a smaller number of CTs, that is, the CTs 16a, 16b, and 16c, as compared to a case where CTs are needed between the breaker tank 12a and each of its adjacent tanks, between the breaker tank 12b and each of its adjacent tanks, and between the breaker tank 12c and each of its adjacent tanks.

The breaker tanks 12a, 12b, and 12c are not limited to being connected to the grounding electrode 18 through the metal base 17. The stands 14a, 14b, and 14c may not be necessarily installed on the metal base 17. The breaker tanks 12a, 12b, and 12c are grounded by connecting a grounding wire provided on each of the breaker tanks 12a, 12b, and 12c to the grounding mesh 19. In this case, the ground-fault current 21 having flowed from the stand 14a to the grounding mesh 19 partially flows through the grounding mesh 19 to the stand 14b and to the stand 14c. This can result in generating the ground-fault currents 22 and 23 similarly to the case when the metal base 17 is used.

Next, a hardware configuration of the fault-point-locating device 1 is described. The function of the computation unit 2 included in the fault-point-locating device 1 is implemented by using a processing circuitry. The processing circuitry is dedicated hardware installed in the fault-point-locating device 1. The processing circuitry may be a processor that executes programs stored in a memory.

FIG. 4 is a first diagram illustrating an example of the hardware configuration of the fault-point-locating device according to the first embodiment. FIG. 4 illustrates the hardware configuration of the fault-point-locating device 1 when the functions of the fault-point-locating device 1 are implemented by using the dedicated hardware. The fault-point-locating device 1 includes a processing circuitry 31 to perform various types of processing, an interface 32 through which the fault-point-locating device 1 is connected to external devices, an external storage device 33 to store therein various types of information, and a display device 34 that is an output device. The processing circuitry 31, the interface 32, the external storage device 33, and the display device 34 are connected to be capable of communicating with each other.

The processing circuitry 31 as dedicated hardware is a single circuit, a combined circuit, a programmed processor, a parallel-programmed processor, an ASIC (Application Specific Integrated Circuit), an FPGA (Field-Programmable Gate Array), or a combination thereof. The functions of the determination unit 6, measurement unit 7, and the location processing unit 8 are implemented by using the processing circuitry 31.

The functions of the pressure-signal input unit 3 and the current-signal input unit 4 are implemented by using the interface 32. The external storage device 33 stores therein the result of location by the location processing unit 8 and the threshold ΔP to be used for determination by the determination unit 6. The display device 34 displays the result of location and other information on a screen. The function of the display unit 5 is implemented by using the display device 34. It is allowable that the fault-point-locating device 1 includes an input device through which the threshold ΔP and other information is input.

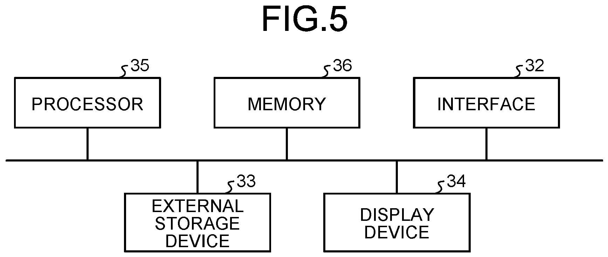

FIG. 5 is a second diagram illustrating an example of the hardware configuration of the fault-point-locating device according to the first embodiment. FIG. 5 illustrates the hardware configuration of the fault-point-locating device when the function of the computation unit 2 is implemented by using hardware that executes the programs. The fault-point-locating device 1 includes a processor 35, a memory 36, the interface 32, the external storage device 33, and the display device 34. The processor 35, the memory 36, the interface 32, the external storage device 33, and the display device 34 are connected to be capable of communicating with each other.

The processor 35 is a CPU (Central Processing Unit), a processing device, a computation device, a microprocessor, a microcomputer, or a DSP (Digital Signal Processor). Each of the functions of the determination unit 6, the measurement unit 7, and the location processing unit 8 is implemented by the processor 35, software, firmware, or a combination of software and firmware. The software or firmware is described as a program to be stored in the memory 36 that is a built-in memory. The memory 36 is a nonvolatile or volatile semiconductor memory, and is a RAM (Random Access Memory), a ROM (Read Only Memory), a flash memory, an EPROM (Erasable Programmable Read Only Memory), or an EEPROM (registered trademark) (Electrically Erasable Programmable Read Only Memory).

According to the first embodiment, the fault-point-locating device 1 measures a waveform of a current flowing between the breaker tank 12a and the grounding electrode 18, a current flowing between the breaker tank 12b and the grounding electrode 18, and a current flowing between the breaker tank 12c and the grounding electrode 18. On the basis of a determination result of whether a pressure increase has occurred in the breaker tanks 12a, 12b, and 12c, and on the basis of a measurement result of the waveform of the currents, the fault-point-locating device 1 performs a process of locating a fault point in the breaker tanks 12a, 12b, and 12c. The fault-point-locating device 1 can reduce the number of CTs to be installed for measurement of the current waveform to the CTs 16a, 16b, and 16c. With this configuration, the fault-point-locating device 1 achieves an effect of reducing the number of constituent elements to be provided in the gas-insulated switchgear 10 to locate a fault point in a tank in which a breaker is accommodated.

### Second embodiment.

In the fault-point-locating device 1 according to a second embodiment, when it is determined that a pressure increase has not occurred in any of the tanks included in the fault-point-locating device 1, that are other than the breaker tanks 12a, 12b, and 12c, the fault-point-locating device 1 locates one of the breaker tanks 12a, 12b, and 12c as a fault point on the basis of a measurement result of the waveform of a current flowing between the breaker tank 12a and the grounding electrode 18, a current flowing between the breaker tank 12b and the grounding electrode 18, and a current flowing between the breaker tank 12c and the grounding electrode 18. In the second embodiment, constituent elements identical to those of the first embodiment are denoted by like reference signs, and configurations different from those of the first embodiment are mainly described.

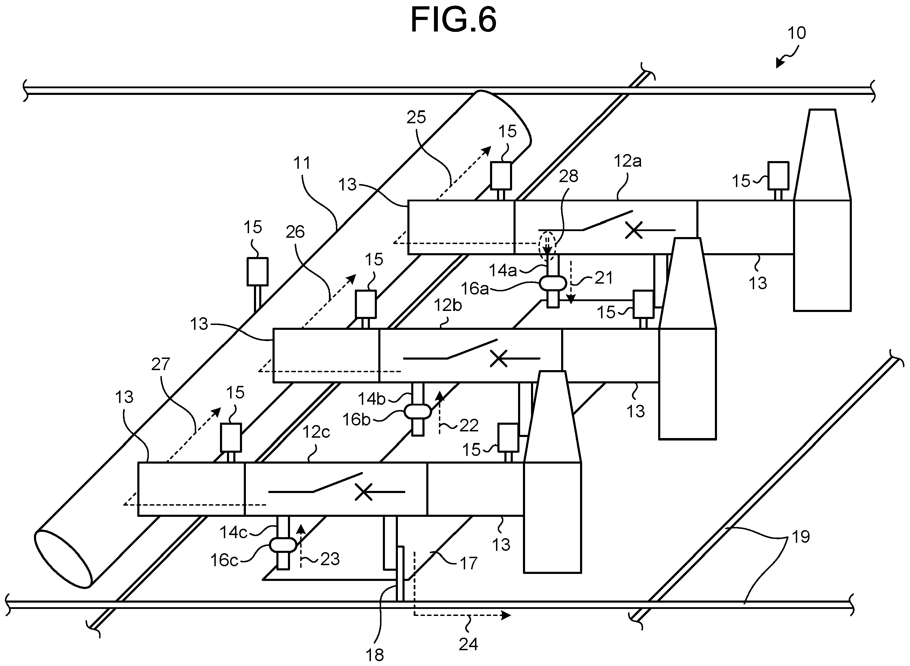

FIG. 6 is a diagram illustrating a schematic configuration of a gas-insulated switchgear that is a target for locating a fault point by the fault-point-locating device according to the second embodiment of the present invention. In the gas-insulated switchgear 10 illustrated in FIG. 6, the pressure sensors 15 are provided respectively on the busbar tank 11 and the connection tanks 13. That is, some of the tanks included in the gas-insulated switchgear 10, other than the breaker tank 12a, the breaker tank 12b, and the breaker tank 12c, are respectively provided with the pressure sensors 15. In the second embodiment, the pressure sensor 15 is not provided on any of the breaker tanks 12a, 12b, and 12c.

The fault-point-locating device 1 according to the second embodiment has a configuration identical to that of the fault-point-locating device 1 illustrated in FIG. 1. In the second embodiment, a pressure signal is input to the pressure-signal input unit 3 from the pressure sensors 15 provided respectively on the busbar tank 11 and the connection tanks 13. The determination unit 6 monitors whether a pressure increase has occurred in the busbar tank 11 and the connection tanks 13 on the basis of pressure signals from the pressure sensors 15 provided on the busbar tank 11 and the connection tanks 13. When the determination unit 6 determines that a pressure increase has occurred in any one of the busbar tank 11 and the connection tanks 13, the location processing unit 8 locates the tank in which a pressure increase is determined to have occurred as a fault point.

On the basis of current signals from the CTs 16a, 16b, and 16c, the measurement unit 7 monitors whether the CTs 16a, 16b, and 16c have detected a current. When a pressure increase is determined not to have occurred in any of the tanks other than the breaker tanks 12a, 12b, and 12c, that is, in any of the busbar tank 11 and the connection tanks 13, and when a current flowing between one of the breaker tanks 12a, 12b, and 12c and the grounding electrode 18 is out of phase with a current flowing between either of the other two breaker tanks and the grounding electrode 18, and a current flowing between the other of the other two breaker tanks and the grounding electrode 18, then the location processing unit 8 locates the one breaker tank as a fault point. When a pressure increase is determined not to have occurred in any of the busbar tank 11 and the connection tanks 13, the location processing unit 8 locates the fault point in the breaker tank 12a, the breaker tank 12b, and the breaker tank 12c on the basis of a measurement result of the waveform of the currents in the same manner as in the first embodiment. Also in the second embodiment, the function of the computation unit 2 included in the fault-point-locating device 1 is implemented by using a processing circuitry similarly to the first embodiment.

In the same manner as in the first embodiment, the fault-point-locating device 1 according to the second embodiment can also reduce the number of CTs to be installed for measurement of a current waveform to the CTs 16a, 16b, and 16c. In the fault-point-locating device 1, the breaker tanks 12a, 12b, and 12c do not need to be provided with the pressure sensors 15, so that the fault-point-locating device 1 can reduce the number of the pressure sensors 15 to be installed for locating a fault point. With this configuration, the fault-point-locating device 1 achieves an effect of reducing the number of constituent elements to be provided in the gas-insulated switchgear 10 to locate a fault point in a tank in which a breaker is accommodated.

The configurations described in the above embodiments are only examples of the content of the present invention. The invention is defined by the appended claims.

### Reference Signs List

1 fault-point-locating device; 2 computation unit; 3 pressure-signal input unit; 4 current-signal input unit; 5 display unit; 6 determination unit; 7 measurement unit; 8 location processing unit; 10 gas-insulated switchgear; 11 busbar tank; 12a, 12b, 12c breaker tank; 13 connection tank; 14a, 14b, 14c stand; 15, 15a, 15b, 15c pressure sensor; 16a, 16b, 16c CT; 17 metal base; 18 grounding electrode; 19 grounding mesh; 21, 22, 23, 24, 25, 26, 27 ground-fault current; 28 position; 31 processing circuitry; 32 interface; 33 external storage device; 34 display device; 35 processor; 36 memory.

## Claims

1. A fault-point-locating device (1) that is configured to locate a fault point in a gas-insulated switchgear (10) including a first tank (12a) having a breaker for a first phase accommodated therein, a second tank (12b) having a breaker for a second phase accommodated therein, and a third tank (12c) having a breaker for a third phase accommodated therein, the fault-point-locating device (1) comprising:
a measurement unit (7) configured to measure a waveform of a current flowing between the first tank (12a) and a grounding electrode (18), a waveform of a current flowing between the second tank (12b) and the grounding electrode (18), and a waveform of a current flowing between the third tank (12c) and the grounding electrode (18), the first tank (12a), the second tank (12b), and the third tank (12c) being connected to the grounding electrode (18);
a location processing unit (8) configured to perform a process of locating the fault point in the first tank (12a), the second tank (12b), and the third tank (12c) on a basis of a measurement result of a waveform of each of the currents, wherein the location processing unit (8) is configured to locate the fault point on a basis of one of the currents being out of phase with each of the other two of the currents; and
a determination unit (6) configured to determine whether a pressure increase has occurred in each of the first tank (12a), the second tank (12b), and the third tank (12c),
**characterized in that** the location processing unit (8) is configured to perform the process of locating the fault point on a basis of a determination result of whether the pressure increase has occurred, and a measurement result of a waveform of each of the currents.

2. The fault-point-locating device (1) according to claim 1, wherein when the pressure increase is determined to have occurred in one tank of the first tank (12a), the second tank (12b), and the third tank (12c), and when a current flowing between the one tank and the grounding electrode (18) is out of phase with a current flowing between either of two of the first tank (12a), the second tank (12b), and the third tank (12c), other than the one tank, and the grounding electrode (18), and a current flowing between the other of the two and the grounding electrode (18), then the location processing unit (8) is configured to locate the one tank as the fault point.

3. The fault-point-locating device (1) according to claim 1, comprising a determination unit (6), wherein the determination unit is configured to determine whether a pressure increase has occurred in each of tanks included in the gas-insulated switchgear (10), except the first tank (12a), the second tank (12b), and the third tank (12c), wherein
when the pressure increase is determined not to have occurred in each of the tanks except the first tank (12a), the second tank (12b), and the third tank (12c), and when a current flowing between one tank of the first tank (12a), the second tank (12b), and the third tank (12c), and the grounding electrode (18) is out of phase with a current flowing between either of two of the first tank (12a), the second tank (12b), and the third tank (12c), other than the one tank, and the grounding electrode (18), and a current flowing between the other of the two and the grounding electrode (18), then the location processing unit (8) is configured to locate the one tank as the fault point.

4. The fault-point-locating device (1) according to claim 1, wherein the measurement unit (7) is configured to measure a waveform of a current detected by a current transformer (16a) attached to a stand (14a) supporting the first tank (12a), a waveform of a current detected by a current transformer (16b) attached to a stand (14b) supporting the second tank (12b), and a waveform of a current detected by a current transformer (16c) attached to a stand (14c) supporting the third tank (12c).

5. A fault-point-locating device (1) that is configured to locate a fault point in a gas-insulated switchgear (10) including a first tank (12a) having a breaker for a first phase accommodated therein, a second tank (12b) having a breaker for a second phase accommodated therein, and a third tank (12c) having a breaker for a third phase accommodated therein, the fault-point-locating device (1) comprising:
a measurement unit (7) configured to measure a waveform of a current flowing between the first tank (12a) and a grounding electrode (18), a waveform of a current flowing between the second tank (12b) and the grounding electrode (18), and a waveform of a current flowing between the third tank (12c) and the grounding electrode (18), the first tank (12a), the second tank (12b), and the third tank (12c) being connected to the grounding electrode (18); and
a location processing unit (8) configured to perform a process of locating the fault point in the first tank (12a), the second tank (12b), and the third tank (12c) on a basis of a measurement result of a waveform of each of the currents,
**characterized in that** the measurement unit (7) is configured to measure a waveform of a current detected by a current transformer (16a) attached to a stand (14a) supporting the first tank (12a), a waveform of a current detected by a current transformer (16b) attached to a stand (14b) supporting the second tank (12b), and a waveform of a current detected by a current transformer (16c) attached to a stand (14c) supporting the third tank (12c).

## Patentansprüche

1. Fehlerstellenortungsvorrichtung (1), die eingerichtet ist, eine Fehlerstelle in einer gasisolierten Schaltanlage (10) zu orten, die einen ersten Tank (12a) mit einem darin untergebrachten Unterbrecher für eine erste Phase, einen zweiten Tank (12b) mit einem darin untergebrachten Unterbrecher für eine zweite Phase und einen dritten Tank (12c) mit einem darin untergebrachten Unterbrecher für eine dritte Phase umfasst, wobei die Fehlerstellenortungsvorrichtung (1) aufweist:
eine Messeinheit (7), die eingerichtet ist, eine Wellenform eines Stroms, der zwischen dem ersten Tank (12a) und einer Erdungselektrode (18) fließt, eine Wellenform eines Stroms, der zwischen dem zweiten Tank (12b) und der Erdungselektrode (18) fließt, und eine Wellenform eines Stroms zu messen, der zwischen dem dritten Tank (12c) und der Erdungselektrode (18) fließt, wobei der erste Tank (12a), der zweite Tank (12b) und der dritte Tank (12c) mit der Erdungselektrode (18) verbunden sind;
eine Ortungsverarbeitungseinheit (8), die eingerichtet ist, einen Vorgang eines Ortens der Fehlerstelle im ersten Tank (12a), im zweiten Tank (12b) und im dritten Tank (12c) basierend auf einem Messergebnis einer Wellenform von jedem der Ströme durchzuführen, wobei die Ortungsverarbeitungseinheit (8) eingerichtet ist, die Fehlerstelle basierend auf einem der Ströme zu orten, der außer Phase ist mit jedem der anderen zwei Ströme; und
eine Bestimmungseinheit (6), die eingerichtet ist, zu bestimmen, ob eine Druckerhöhung in jedem von dem ersten Tank (12a), dem zweiten Tank (12b) und dem dritten Tank (12c) aufgetreten ist,
**dadurch gekennzeichnet, dass** die Ortungsverarbeitungseinheit (8) eingerichtet ist, den Vorgang eines Ortens der Fehlerstelle basierend auf einem Bestimmungsergebnis, ob die Druckerhöhung aufgetreten ist, und einem Messergebnis einer Wellenform von jedem der Ströme durchzuführen.

2. Fehlerstellenortungsvorrichtung (1) nach Anspruch 1, wobei, wenn es bestimmt wird, dass die Druckerhöhung in einem Tank von dem ersten Tank (12a), dem zweiten Tank (12b) und dem dritten Tank (12c) aufgetreten ist, und wenn ein Strom, der zwischen dem einen Tank und der Erdungselektrode (18) fließt, außer Phase mit einem Strom ist, der zwischen jedem der zwei von dem ersten Tank (12a), dem zweiten Tank (12b) und dem dritten Tank (12c), der anders als der eine Tank ist, und der Erdungselektrode (18) fließt und wenn ein Strom zwischen den anderen zwei und der Erdungselektrode (18) fließt, die Ortungsverarbeitungseinheit (8) dann eingerichtet ist, den einen Tank als die Fehlerstelle zu orten.

3. Fehlerstellenortungsvorrichtung (1) nach Anspruch 1, die eine Bestimmungseinheit (6) aufweist, wobei die Bestimmungseinheit eingerichtet ist, zu bestimmen, ob eine Druckerhöhung aufgetreten ist in jedem von Tanks, die von der gasisolierten Schaltanlage (10) umfasst sind, außer dem ersten Tank (12a), dem zweiten Tank (12b) und dem dritten Tank (12c), wobei,
wenn es bestimmt wird, dass die Druckerhöhung nicht stattgefunden hat in jedem der Tanks außer dem ersten Tank (12a), dem zweiten Tank (12b) und dem dritten Tank (12c) und wenn ein Strom, der zwischen einem Tank von dem ersten Tank (12a), dem zweiten Tank (12b) und dem dritten Tank (12c) und der Erdungselektrode (18) fließt, außer Phase mit einem Strom ist, der zwischen jeder von zwei von dem ersten Tank (12a), dem zweiten Tank (12b) und dem dritten Tank (12c), der sich von dem einen Tank unterscheidet, und der Erdungselektrode (18) fließt, und ein Strom, der zwischen den anderen zwei und der Erdungselektrode (18) fließt, die Ortungsverarbeitungseinheit (8) dann eingerichtet ist, den einen Tank als die Fehlerstelle zu orten.

4. Fehlerstellenortungsvorrichtung (1) nach Anspruch 1, wobei die Messeinheit (7) eingerichtet ist, eine Wellenform eines Stroms, der durch einen Stromtransformator (16a) erfasst wird, der an einem Ständer (14a) angebracht ist, der den ersten Tank (12a) trägt, eine Wellenform eines Stroms, der durch einen Stromtransformator (16b) erfasst wird, der an einem Ständer (14b) angebracht ist, der den zweiten Tank (12b) trägt, und eine Wellenform eines Stroms zu messen, der durch einen Stromtransformator (16c) erfasst wird, der an einem Ständer (14c) angebracht ist, der den dritten Tank (12c) trägt.

5. Fehlerstellenortungsvorrichtung (1), die eingerichtet ist, eine Fehlerstelle in einer gasisolierten Schaltanlage (10) zu orten, die einen ersten Tank (12a) mit einem darin untergebrachten Unterbrecher für eine erste Phase, einen zweiten Tank (12b) mit einem darin untergebrachten Unterbrecher für eine zweite Phase und einen dritten Tank (12c) mit einem darin untergebrachten Unterbrecher für eine dritte Phase umfasst, wobei die Fehlerstellenortungsvorrichtung (1) aufweist:
eine Messeinheit (7), die eingerichtet ist, eine Wellenform eines Stroms, der zwischen dem ersten Tank (12a) und einer Erdungselektrode (18) fließt, eine Wellenform eines Stroms, der zwischen dem zweiten Tank (12b) und der Erdungselektrode (18) fließt, und eine Wellenform eines Stroms zu messen, der zwischen dem dritten Tank (12c) und der Erdungselektrode (18) fließt, wobei der erste Tank (12a), der zweite Tank (12b) und der dritte Tank (12c) mit der Erdungselektrode (18) verbunden sind; und
eine Ortungsverarbeitungseinheit (8), die eingerichtet ist, einen Vorgang eines Ortens der Fehlerstelle in dem ersten Tank (12a), dem zweiten Tank (12b) und dem dritten Tank (12c) basierend auf einem Messergebnis einer Wellenform von jedem der Ströme durchzuführen,
**dadurch gekennzeichnet, dass** die Messeinheit (7) eingerichtet ist, eine Wellenform eines Stroms, der durch einen Stromtransformator (16a) erfasst wird, der an einem Ständer (14a) angebracht ist, der den ersten Tank (12a) trägt, eine Wellenform eines Stroms, der durch einen Stromtransformator (16b) erfasst wird, der an einem Ständer (14b) angebracht ist, der den zweiten Tank (12b) trägt, und eine Wellenform eines Stroms zu messen, der durch einen Stromtransformator (16c) erfasst wird, der an einem Ständer (14c) angebracht ist, der den dritten Tank (12c) trägt.

## Revendications

1. Dispositif de localisation de point de défaillance (1) qui est configuré pour localiser un point de défaillance dans un appareillage de commutation isolé au gaz (10) comportant un premier réservoir (12a) ayant un disjoncteur pour une première phase qui y est logé, un deuxième réservoir (12b) ayant un disjoncteur pour une deuxième phase qui y est logé, et un troisième réservoir (12c) ayant un disjoncteur pour une troisième phase qui y est logé, le dispositif de localisation de point de défaillance (1) comprenant :
une unité de mesure (7) configurée pour mesurer une forme d'onde d'un courant circulant entre le premier réservoir (12a) et une électrode de mise à la terre (18), une forme d'onde d'un courant circulant entre le deuxième réservoir (12b) et l'électrode de mise à la terre (18), et une forme d'onde d'un courant circulant entre le troisième réservoir (12c) et l'électrode de mise à la terre (18), le premier réservoir (12a), le deuxième réservoir (12b), et le troisième réservoir (12c) étant connectés à l'électrode de mise à la terre (18) ;
une unité de traitement de localisation (8) configurée pour effectuer un processus de localisation du point de défaillance dans le premier réservoir (12a), le deuxième réservoir (12b), et le troisième réservoir (12c) en fonction d'un résultat de mesure d'une forme d'onde de chacun des courants, dans lequel l'unité de traitement de localisation (8) est configurée pour localiser le point de défaillance en fonction d'un des courants qui est déphasé par rapport à chacun des deux autres courants ; et
une unité de détermination (6) configurée pour déterminer si une augmentation de pression s'est produite dans chacun parmi le premier réservoir (12a), le deuxième réservoir (12b), et le troisième réservoir (12c),
**caractérisé en ce que** l'unité de traitement de localisation (8) est configurée pour effectuer le processus de localisation du point de défaillance en fonction d'un résultat de détermination indiquant si l'augmentation de pression s'est produite, et d'un résultat de mesure d'une forme d'onde de chacun des courants.

2. Dispositif de localisation de point de défaillance (1) selon la revendication 1, dans lequel, lorsque l'augmentation de pression est déterminée comme s'étant produite dans un réservoir parmi le premier réservoir (12a), le deuxième réservoir (12b), et le troisième réservoir (12c), et lorsqu'un courant circulant entre ledit réservoir et l'électrode de mise à la terre (18) est déphasé par rapport à un courant circulant entre l'un ou l'autre de deux réservoirs parmi le premier réservoir (12a), le deuxième réservoir (12b), et le troisième réservoir (12c), autre que ledit réservoir, et l'électrode de mise à la terre (18), et un courant circulant entre l'autre des deux réservoirs et l'électrode de mise à la terre (18), alors l'unité de traitement de localisation (8) est configurée pour localiser ledit réservoir comme point de défaillance.

3. Dispositif de localisation de point de défaillance (1) selon la revendication 1, comprenant une unité de détermination (6), dans lequel l'unité de détermination est configurée pour déterminer si une augmentation de pression s'est produite dans chacun des réservoirs inclus dans l'appareillage de commutation isolé au gaz (10), à l'exception du premier réservoir (12a), du deuxième réservoir (12b), et du troisième réservoir (12c), dans lequel
lorsque l'augmentation de pression est déterminée comme ne s'étant pas produite dans chacun des réservoirs, à l'exception du premier réservoir (12a), du deuxième réservoir (12b), et du troisième réservoir (12c), et lorsqu'un courant circulant entre un réservoir parmi le premier réservoir (12a), le deuxième réservoir (12b), et le troisième réservoir (12c), et l'électrode de mise à la terre (18) est déphasé par rapport à un courant circulant entre l'un ou l'autre de deux réservoirs parmi le premier réservoir (12a), le deuxième réservoir (12b), et le troisième réservoir (12c), autre que ledit réservoir, et l'électrode de mise à la terre (18), et un courant circulant entre l'autre des deux réservoirs et l'électrode de mise à la terre (18), alors l'unité de traitement de localisation (8) est configurée pour localiser ledit réservoir comme point de défaillance.

4. Dispositif de localisation de point de défaillance (1) selon la revendication 1, dans lequel l'unité de mesure (7) est configurée pour mesurer une forme d'onde d'un courant détecté par un transformateur de courant (16a) fixé à un support (14a) soutenant le premier réservoir (12a), une forme d'onde d'un courant détecté par un transformateur de courant (16b) fixé à un support (14b) soutenant le deuxième réservoir (12b), et une forme d'onde d'un courant détecté par un transformateur de courant (16c) fixé à un support (14c) soutenant le troisième réservoir (12c).

5. Dispositif de localisation de point de défaillance (1) qui est configuré pour localiser un point de défaillance dans un appareillage de commutation isolé au gaz (10) comportant un premier réservoir (12a) ayant un disjoncteur pour une première phase qui y est logé, un deuxième réservoir (12b) ayant un disjoncteur pour une deuxième phase qui y est logé, et un troisième réservoir (12c) ayant un disjoncteur pour une troisième phase qui y est logé, le dispositif de localisation de point de défaillance (1) comprenant :
une unité de mesure (7) configurée pour mesurer une forme d'onde d'un courant circulant entre le premier réservoir (12a) et une électrode de mise à la terre (18), une forme d'onde d'un courant circulant entre le deuxième réservoir (12b) et l'électrode de mise à la terre (18), et une forme d'onde d'un courant circulant entre le troisième réservoir (12c) et l'électrode de mise à la terre (18), le premier réservoir (12a), le deuxième réservoir (12b), et le troisième réservoir (12c) étant connectés à l'électrode de mise à la terre (18) ; et
une unité de traitement de localisation (8) configurée pour effectuer un processus de localisation du point de défaillance dans le premier réservoir (12a), le deuxième réservoir (12b), et le troisième réservoir (12c) en fonction d'un résultat de mesure d'une forme d'onde de chacun des courants, **caractérisé en ce que** l'unité de mesure (7) est configurée pour mesurer une forme d'onde d'un courant détecté par un transformateur de courant (16a) fixé à un support (14a) soutenant le premier réservoir (12a), une forme d'onde d'un courant détecté par un transformateur de courant (16b) fixé à un support (14b) soutenant le deuxième réservoir (12b), et une forme d'onde d'un courant détecté par un transformateur de courant (16c) fixé à un support (14c) soutenant le troisième réservoir (12c).
